# EUROPEAN PATENT SPECIFICATION

(11) **EP 0 622 680 B1**
(45) Date of publication and mention of the grant of the patent: **06.05.1999**
(21) Application number: 94400689.9
(22) Date of filing: 30.03.1994
(51) Int. Cl.: G03F 1/14

(54) **Frame-supported dustproof pellicle for photolithographic photomask**
Rahmengestützte Membranabdeckung zum Schutz gegen Staub für photolithographische Photomasken
Opercule pelliculaire supporté par un châssis pour la protection contre la poussière de masques photolithographiques

(30) Priority: 13.04.1993 JP 109952/93
(43) Date of publication of application: 02.11.1994
(73) Proprietor: SHIN-ETSU CHEMICAL CO., LTD., Chiyoda-ku Tokyo (JP)
(72) Inventor: Kubota, Yoshihiro, Takasaki-shi, Gunma-ken (JP); Kashida, Meguru, Annaka-shi, Gunma-ken (JP); Kawaguchi, Sakae, Annaka-shi, Gunma-ken (JP); Nagata, Yoshihiko, Annaka-shi, Gunma-ken (JP); Hamada, Yuichi, Annaka-shi, Gunma-ken (JP); Shirasaki, Toru, Annaka-shi, Gunma-ken (JP)
(74) Representative: Armengaud Ainé, Alain

(56) References cited:
- EP-A- 0 416 528
- EP-A- 0 482 821
- EP-A- 0 488 788
- EP-A- 0 564 348
- US-A- 4 657 805

## Description

### BACKGROUND OF THE INVENTION

The present invention relates to a frame-supported dustproof pellicle for a photolithographic photomask used in the patterning works in the manufacture of, for example, fine electronic materials such as semiconductor devices and liquid display panels. More particularly, the invention relates to a frame-supported dustproof pellicle for a photolithographic photomask, which is almost completely freed from the troubles due to occurrence of dust particles from the pellicle frame *per se.*

As is known, the photolithographic method is well established in the patterning works for the manufacture of semiconductor devices, such as LSIs, VLSIs and the like, liquid crystal display panels and other electronic materials, in which the photoresist layer formed on the surface of a substrate such as a silicon semiconductor wafer is pattern-wise irradiated with ultraviolet light through a transparency called a photomask followed by development to form a patterned resist layer. In view of the extremely high fineness and precision required in this patterning work, it is very important that the photomask is absolutely dust-free since, when dust particles are deposited on the photomask, the ultraviolet light passing through the photomask is necessarily scattered by the dust particles to give a great influence on the quality of the reproduced pattern such as fidelity to the photomask pattern and contrast of the images.

It is therefore a usual practice that the photolithographic patterning work is conducted in a clean room under an atmosphere freed from any floating dust particles as completely as possible although perfect cleanness can hardly be obtained even in a clean room of the highest cleanness. Accordingly, deposition of dust particles on the photomask must be prevented by mounting a frame-supported dustproof pellicle on the photomask. The frame-supported dustproof pellicle above mentioned is a device consisting of a frame made from a rigid material such as an aluminum alloy and a thin, highly transparent film of a polymer, which is called a pellicle membrane, stretched over and adhesively bonded to one end surface of the frame in a drumhead-like slack-free fashion.

When a frame-supported pellicle is mounted on the photomask, the dust particles floating in the atmospheric air and falling therefrom are never deposited directly on the photomask but deposited on the pellicle membrane. Since the light beams used for the pattern-wise irradiation are focused at the patterned images on the photomask, the dust particles deposited on the pellicle membrane, which is held apart above the photomask, have little adverse influences on the quality of pattern reproduction in the photolithography.

US-A-4 657 805, EP-A-042 8821 and 0 416 528 disclose frame-supported pellicles which comprise a transparent pellicle membrane adhesively bonded to the frame which may consist of aluminum.

In the prior art, the pellicle frame is shaped from a rigid material such as aluminum-based alloys, stainless steels, polyethylene resins and the like and a transparent pellicle membrane of a polymer such as nitrocellulose, cellulose acetate, modified polyvinyl alcohol, fluorocarbon resin and the like is, as is taught in Japanese Patent Kokai 58-219023, applied to one end surface of the pellicle frame wet with a good solvent of the polymer followed by air-drying to effect adhesive bonding of the membrane to the pellicle frame or is adhesively bonded to one end surface of the frame by using an acrylic or epoxy resin-based adhesive as is taught in U.S. Patent 4,861,403 and Japanese Patent Publication 63-27707. Preferably, the other end surface of the pellicle frame is coated with a pressure-sensitive adhesive such as those based on a polybutene resin, polyvinyl acetate resin, acrylic resin and the like in order to facilitate mounting and immobilization thereof on the photomask. The end surface of the frame coated with a pressure-sensitive adhesive is temporarily protected from inadvertent sticking by attaching a removable surface-release sheet or film.

In view of the dustproofing object of the use of a frame-supported pellicle, it is essential that any parts of the pellicle frame and membrane are absolutely free from deposit of dust particles thereon and are not responsible for the occurrence of dust particles therefrom. Therefore, extreme care is required in the preparation of frame-supported pellicles but nevertheless perfectly dust-free conditions can hardly be obtained and one of the problems to be solved is occurrence of dust particles from the pellicle frame *per se.*

Among the materials for the pellicle frames including aluminum-based alloys, stainless steels, polyethylene resins and the like above mentioned, aluminum-based alloys are preferred in respects of the high mechanical strengths relative to the lightness in weight and high hardness to ensure durability of the frame-supported pellicle. It is usual that the surface of the pellicle frame of an aluminum alloy is subjected to an anodization treatment in order to further improve the stability of the frame against the influence of the atmosphere and the thus anodized surface layer of the pellicle frame is stained in black color in order to minimize the adverse influences of the stray light on the quality of the reproduced image pattern obtained in the photolithographic patterning works.

As is mentioned above, it is always the case that dust particles in a number more than negligible are found as deposited on the photomask even when it is under dustproof protection by mounting a frame-supported pellicle thereon notwithstanding the utmost care undertaken in the manufacture of frame-supported pellicles to ensure dust-free conditions. Despite the demand for obtaining a frame-supported pellicle freed from the problem of dust particle occurrence, no proposals and attempts have been made heretofore to solve this problem because the mechanism leading to occurrence of dust particles is not well understood.

### SUMMARY OF THE INVENTION

The present invention accordingly has an object to provide a frame-supported pellicle for the dustproof protection of a photomask in the photolithographic patterning works, by which greatly improved dust-free conditions can be ensured on the photomask protected by mounting the same thereon.

Thus, the frame -supported pellicle for dustproof protection of a photomask used in a photolithographic patterning work comprises :
a) a pellicle frame made from aluminum or an aluminum-based alloy having a surface layer formed by an anodization treatment and stained in black color ;
b) a pellicle membrane which is a transparent film of an organic polymer stretched over and adhesively bonded to one of the end of the end surfaces of the pellicle frame ; and
c) a layer of an organic polymer coating the entire surface of the pellicle frame excepting the surface area to which the pellicle membrane is adhesively bonded.

In particular, the pellicle frame made from aluminum or an aluminum-based alloy is anodized on the surface and the organic polymer forming the coating layer on the frame surface is preferably an amorphous fluorine-containing polymer free from tackiness on the surface.

### DETAILED DESCRIPTION OF THE PREFERRED EMBODIMENTS

The above defined present invention has been completed as a result of the extensive investigations undertaken by the inventors in order to develop a frame-supported pellicle which is free from the troubles due to dust particle deposition on the photomask when used by mounting thereon. Namely, the inventors have first conducted analysis of the mechanism for the occurrence of dust particles even from a frame-supported pellicle prepared under utmost care leading to a quite unexpected discovery that, although the surface of a pellicle frame made from aluminum or an aluminum-based alloy, in particular, after an anodization treatment is very smooth at least as viewed by naked eyes, the surface is, microscopically, far from a smooth surface but rather is rugged with numberless protrusions and fissure-like recesses as is seen on the scanning electron microscopic photographs.

When this unexpectedly discovered fact is kept in mind, it is not surprising that quite a large number of dust particles are always found on the photomask used under dustproof protection by mounting a frame-supported pellicle notwithstanding the utmost care undertaken in the preparation of the frame-supported pellicle for dust-free conditions and the conventional measure of coating the inside surface of the pellicle frame with a sticking agent to capture the dust particles floating in the air confined by the photomask and the pellicle or with a coating composition to prevent occurrence of dust particles from the inside surface of the pellicle frame. Namely, it is a usual way of handling of frame-supported pellicles that they are encased one by one in a holder case made, for example, from a plastic resin so that rubbing takes place unavoidably between the inner surface of the holder case and the outer surface of the pellicle frame during handling and, in particular, transportation of the encased frame-supported pellicles from the manufacturing plant to the users thereof resulting in formation of dust particles because the rugged surface of the anodized layer is relatively brittle.

By further continuing their investigations to solve the above described problem, the inventors have arrived at a discovery that the phenomenon of dust particle occurrence from the surface of the pellicle frame *per se* can be prevented by forming a coating layer of an organic polymer on all over the surface of the pellicle frame made from aluminum or an aluminum-based alloy and subjected to anodization leading to completion of the present invention after confirmation of the remarkable effectiveness of such a frame-supported pellicle despite the simplicity and inexpensiveness of the means.

The frame to be used as the pellicle frame of the inventive frame-supported pellicle can be conventional including the material forming the frame and the form and dimensions thereof although the present invention is most favorably applicable to those made from aluminum or an aluminum-based alloy after an anodization treatment of the surface and staining of the anodized surface layer in black color. The aluminum-based alloy here implied is an alloy mainly consisting of aluminum or containing at least 50% by weight of aluminum and susceptible to the anodization treatment. The conditions for this anodization treatment for the formation of an anodized surface layer and black staining of the surface layer can be conventional without particular limitations.

As the characteristic feature of the inventive frame-supported pellicle, the surface of the pellicle frame is entirely coated with a coating layer of an organic resin so that the microscopically very rugged surface of the pellicle frame of an aluminum-based alloy after anodization can be smoothed and is no longer responsible for the occurrence of dust particles from the rugged surface even when the pellicle frame is rubbed with the inner surface of a holder case during transportation although various methods are applicable for the purpose of smoothing of the frame surface including metal-plating, treatment with a glass frit of low melting point, CVD treatment, sputtering treatment and so on. It is not always essential that the end surface of the pellicle frame to which the pellicle membrane is adhesively bonded is provided with a coating layer of the organic resin but a convenient way is that the whole surface of the pellicle frame is subjected to a coating treatment with an organic resin before adhesive bonding of the pellicle membrane to one of the end surfaces of the pellicle frame.

Various kinds of organic resins can be used for the purpose of surface coating of the pellicle frame including thermoplastic and thermosetting resins such as acrylic resins, epoxy resins, silicone resins, fluorocarbon resins and the like. The method for coating the surface of the pellicle frame with these organic resins can be conventional including the methods of spraying of a solution of the resin, dipping of the frame in a solution of the resin followed by drying, electrostatic coating, electrodeposition coating and the like depending on the types of the organic resins. The thickness of the resinous coating layer on the pellicle frame is in the range from 0.1 to 10 µm or, preferably, from 0.5 to 2 µm. When the thickness of the coating layer is too small, the desired effect of smoothing of the frame surface can be obtained only insufficiently while, when the thickness is too large, an economical disadvantage is caused due to the increase in the cost for the coating treatment without further increase in the smoothing effect of the frame surface.

The organic resin for the coating treatment of the frame surface must satisfy several requirements including transparency not to hide the black-stained surface of the pellicle frame, easiness of the coating works therewith such as solubility in an organic solvent, high mechanical strengths such as high hardness and resistance against scratches and mechanical shocks, absence of tackiness on the surface, lubricity on the surface, susceptibility to adhesive bonding of the pellicle membrane, stability against irradiation with ultraviolet light and so on. In this regard, the inventors have continued extensive investigations in order to find an organic polymer suitable as a material of coating on the pellicle frame and have arrived at a discovery that the above mentioned requirements can be mostly satisfied with a specific amorphous fluorine-containing polymer leading to completion of the present invention after experimental confirmation that almost no dust particles are produced from the pellicle frame *per se* when the frame surface is coated with such an organic polymer.

Several types of amorphous fluorine-containing polymers are available on the market including copolymers of tetrafluoroethylene and a fluorine-containing monomeric compound having a cyclic perfluoroether group in a molecule. Examples of suitable commercial products include those sold under the trade name of Teflon AF (a product by Du Pont Co.) which is a copolymer consisting of the monomeric units as expressed by the formula 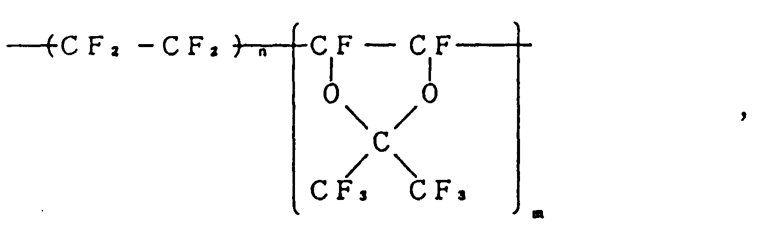 in which the subscripts m and n are each a positive integer with the proviso that the ratio m/(m+n) = 0.66, and Sytop A (a product by Asahi Glass Co.) which is a copolymer consisting of the monomeric units as expressed by the formula 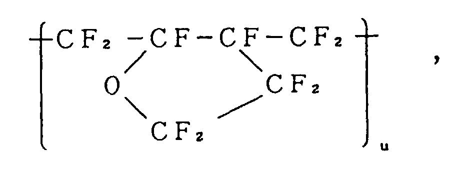 in which the subscript u is a positive integer. These fluorine-containing organic polymers have good solubility in certain fluorine-containing organic solvents mainly consisting of, for example, per-fluoro(2-butyl tetrahydrofuran) such as a commercial product sold under a trade name of Florinert FC-75 (a product by 3M Co.) to give a uniform solution so that the pellicle frame can be easily coated with the solution by the method of spraying of the solution or dipping of the frame in the solution followed by drying. Thickness of the coating layer can be readily controlled by adequately adjusting the concentration of the polymer in the coating solution. The adhesiveness of the coating layer of these polymers to the anodized surface of a pellicle frame of an aluminum-based alloy is usually good but adhesion therebetween can be further improved by the addition of an adhesion-improving agent or by the modification of the polymer.

The pellicle frame after coating with an organic resin in the above described manner is then provided with a pellicle membrane by adhesive bonding to one of the end surfaces in a drumhead-like slack-free fashion. The material and thickness of the pellicle membrane as well as the method for adhesively bonding the same to one of the end surfaces of the pellicle frame can be conventional without particular limitations although the pellicle membrane is made preferably from an amorphous fluorine-containing polymer such as those used in the coating work of the frame surface or those similar thereto because these polymers have good film formability and the films therefrom are highly transparent and resistant against ultraviolet irradiation. The frame-supported pellicle of the invention is completed by adhesively bonding the pellicle membrane to the end surface of the pellicle frame provided with a coating layer of an organic polymer but it is optional that the inner surface of the pellicle frame is further coated with a sticking agent with an object to form a dust-capturing surface.

In the following, a frame-supported pellicle is described in more detail by way of comparative examples not covered by the claims.

### Comparative Example 1 and Comparative Example 2.

A coating solution of an organic polymer was prepared in Example 1 by dissolving Teflon AF *(supra)* in a solvent Florinert FC-75 *(supra)* in a concentration of 8.0% by weight. A rectangular frame of an aluminum-based alloy, of which the inner dimensions were 116 mm by 94 mm, the outer dimensions were 120 mm by 98 mm, the height was 5.8 mm and the surface was anodized and stained in black, was immersed in the coating solution and pulled up therefrom followed by drying at 150 °C to form a coating layer on the whole surface of the frame. The thickness of the coating layer was about 1.5 µm.

A film of nitrocellulose having a thickness of 0.86 µm as a pellicle membrane was adhesively bonded to one of the end surfaces of the pellicle frame by using an epoxy resin-based adhesive in a conventional manner while the other end surface of the frame was coated with a silicone-based pressure-sensitive adhesive agent and the sticky surface was protected by attaching a surface-release sheet coated with a fluorocarbon resin. The thus prepared frame-supported pellicle was encased in a polyethylene-made holder case and subjected to a transportation test on truck over a distance of about 2500 kilometers via a highway. The frame-supported pellicle after the transportation test was taken out of the case and subjected to an inspection for dust deposition by counting the number of the dust particles of 0.3 µm or larger deposited on a 116 mm by 94 mm area of the pellicle membrane by using a laser beam detector to find absolutely no deposition of dust particles thereon. Needless to say, no dust particles were found on the pellicle membrane before the transportation test.

Separately, in Comparative Example 2, another frame-supported pellicle was prepared in the same manner as above excepting omission of the coating treatment of the pellicle frame with Teflon AF and this comparative pellicle was subjected concurrently to the transportation test to detect 32 dust particles on the 116 mm by 94 mm area of the pellicle membrane while no dust particles were found on the pellicle membrane before the transportation test.

### Comparative Example 3 and Comparative Example 4.

The procedures for the preparation and testing of frame-supported pellicles in Comparative Example 3 and Comparative Example 4 were substantially the same as in Comparative Example 1 and Comparative Example 2, respectively, described above except that the coating solution for the pellicle frame was prepared by dissolving Sytop A *(supra)* in Florinert FC-75 *(supra)* in a concentration of 5.0% by weight, with which a coating layer of the resin on the frame surface having a thickness of 1.5 µm as dried was obtained, the pellicle membrane having a thickness of 0.82 µm was prepared from another grade of Sytop resins (Sytop S, a product by Asahi Glass Co.), the silicone resin-based pressure-sensitive adhesive was replaced with a polybutene-based pressure-sensitive adhesive and the surface-release sheet coated with a fluorocarbon resin was replaced with that coated with a silicone.

The results of the transportation test were that absolutely no dust particle deposition was detected on the pellicle membrane bonded to the surface-coated pellicle frame in Comparative Example 3 and 16 dust particles were detected on the 116 mm by 94 mm area of the pellicle membrane bonded to the uncoated pellicle frame in Comparative Example 4 while no dust particles were found on the pellicle membrane before the transportation test.

## Claims

1. A frame-supported pellicle for dustproof protection of a photomask used in a photolithographic patterning work which comprises :
a) a pellicle frame made from aluminum or an aluminum-based alloy having a surface layer formed by an anodization treatment and stained in black color ;
b) a pellicle membrane which is a transparent film of an organic polymer stretched over and adhesively bonded to one of the end of the end surfaces of the pellicle frame ; and
c) a layer of an organic polymer coating the entire surface of the pellicle frame excepting the surface area to which the pellicle membrane is adhesively bonded.

2. Frame-supported pellicle as claimed in claim 1 characterized in that the organic polymer for the coating layer on the surface of the pellicle frame is a fluorine-containing polymer having an amorphous structure.

3. Frame-supported pellicle as claimed in claim 1 characterized in that the coating layer of the organic polymer has a thickness in the range from 0.1 to 10 µm.

## Patentansprüche

1. Durch einen Rahmen gestützter Film zum staubdichten Schutz einer Photomaske, welcher bei einem photolithographischen Strukturierungsverfahren verwendet wird, umfassend:
a) einen Filmrahmen, welcher aus Aluminium oder einer Legierunc auf Aluminiumbasis hergestellt ist, eine durch eine Anodisierungsbehandlung gebildete Oberflächenschicht besitzt und schwarz gefärbt ist,
b) eine Filmmembran, welche eine transparente Folie aus einem organischen Polymer ist, die über eines der Enden der Endenoberfläche des Filmrahmens gespannt und damit durch Kleben verbunden ist,
c) eine Schicht aus einem organischen Polymer, mit der die gesamte Oberfläche des Filmrahmens überzogen ist, mit Ausnahme des Oberflächenbereichs, mit dem die Filmmembran durch Kleben verbunden ist.

2. Durch einen Rahmen gestützter Film nach Anspruch 1, dadurch gekennzeichnet, daß das organische Polymer für die Überzugsschicht auf der Oberfläche des Filmrahmens ein fluorhaltiges Polymer mit eier amorphen Struktur ist.

3. Durch einen Rahmen gestützter Film nach Anspruch 1, dadurch gekennzeichnet, daß die Überzugsschicht aus dem organischen Polymer eine Dicke im Bereich von 0,1 bis 10 µm hat.

## Revendications

1. Opercule pelliculaire supporté par un châssis pour la protection contre la poussière d'un photomasque utilisé dans une opération de configuration photolothographique qui comprend :
a) un châssis pour opercule pelliculaire constitué d'aluminium ou d'un alliage à base d'aluminium présentant une couche de surface formée par un traitement d'anodisation et teintée de couleur noire ;
b) une membrane pelliculaire qui est un film transparent d'un polymère organique tendu sur, et fixé de façon adhésive à, l'une des extrémités des surfaces d'extrémité du châssis pour opercule pelliculaire ; et
c) une couche de polymère organique recouvrant toute la surface du châssis pour opercule pelliculaire , sauf la zone de la surface sur laquelle la membrane pelliculaire est fixée de façon adhésive.

2. Opercule pelliculaire supporté par un châssis selon la revendication 1, caractérisé en ce que le polymère organique destiné à la couche de recouvrement de la surface du châssis pour opercule pelliculaire est un polymère contenant du fluor présentant une structure amorphe.

3. Opercule pelliculaire supporté par châssis selon la revendication 1, caractérisé en ce que la couche de recouvrement de polymère organique présente une épaisseur située dans la plage de 0,1 à 10 µm.
